# DEMANDE DE BREVET EUROPEEN

(11) **EP 4 601 193 A1**
(43) Date de publication de la demande: **13.08.2025**
(21) Numéro de dépôt: 25154500.0
(22) Date de dépôt: 28.01.2025
(51) Int. Cl.: H03H 9/54, H03H 9/05

(54) **CIRCUIT ÉLECTRONIQUE DE FILTRAGE**

(30) Priorité: 08.02.2024 FR 2401259
(71) Demandeur: STMicroelectronics International N.V., 1228 Plan-les-Ouates, Geneva (CH)
(72) Inventeur: BOUFNICHEL, Mohamed, 37380 Monnaie (FR)
(74) Mandataire: Cabinet Beaumont

(57) **Abrégé**

La présente description concerne un circuit électronique de filtrage (100) comprenant :
- un dispositif passif intégré (101) ;
- un filtre à ondes acoustiques de volume (151) superposé au dispositif passif intégré (101) du côté d'une première face (103B) du dispositif passif intégré (101) ; et
- au moins un pilier conducteur (181) traversant le dispositif passif intégré (101) et connectant une électrode (157) du filtre à ondes acoustiques de volume (151) à un élément de reprise de contact (113) situé sur une deuxième face (103A) du dispositif passif intégré (101) opposée à la première face (103B) et destiné à être connecté à un élément extérieur (117).

## Description

### Domaine technique

La présente description concerne de façon générale les dispositifs électroniques, plus particulièrement les circuits électroniques de filtrage.

### Technique antérieure

De nombreux dispositifs électroniques comprennent au moins un circuit électronique de filtrage. De tels circuits sont par exemple intégrés dans des téléphones mobiles, ou smartphones, pour éviter que le fonctionnement d'un canal de réception de communications radiofréquence du téléphone ne soit perturbé par des interférences causées par des signaux radiofréquence émis par d'autres dispositifs électroniques, ou par du bruit provenant de sources radiofréquence externes. Les circuits électroniques de filtrage existants souffrent toutefois de divers inconvénients.

### Résumé de l'invention

Il existe un besoin de pallier tout ou partie des inconvénients des circuits électroniques de filtrage existants.

Pour cela, un mode de réalisation prévoit un circuit électronique de filtrage comprenant :
- un dispositif passif intégré ;
- un filtre à ondes acoustiques de volume superposé au dispositif passif intégré du côté d'une première face du dispositif passif intégré ; et
- au moins un pilier conducteur traversant le dispositif passif intégré et connectant une électrode du filtre à ondes acoustiques de volume à un élément de reprise de contact situé sur une deuxième face du dispositif passif intégré opposée à la première face et destiné à être connecté à un élément extérieur.

Selon un mode de réalisation, le dispositif passif intégré forme un capot du filtre à ondes acoustiques de volume.

Selon un mode de réalisation, la première face délimite, avec une troisième face du filtre à ondes acoustiques de volume située en vis-à-vis de la première face, une cavité.

Selon un mode de réalisation, la cavité présente une épaisseur définie par une hauteur dudit au moins un pilier conducteur, ledit au moins un pilier conducteur formant saillie sur la première face.

Selon un mode de réalisation, la cavité est délimitée latéralement par un mur périphérique.

Selon un mode de réalisation, le mur périphérique est en un matériau isolant, de préférence un matériau polymère.

Selon un mode de réalisation, ledit au moins un pilier conducteur est situé à l'intérieur de la cavité.

Selon un mode de réalisation, le dispositif passif intégré comporte un premier substrat semiconducteur comprenant une région dans et sur laquelle est formé au moins un filtre, de préférence au moins un filtre passe-bande, plus préférentiellement un filtre RLC.

Selon un mode de réalisation, le filtre à ondes acoustiques de volume comporte un deuxième substrat semiconducteur comprenant une région dans et sur laquelle est formée une structure de filtre à ondes acoustiques de volume connectée à l'électrode.

Un mode de réalisation prévoit un dispositif électronique, de préférence un téléphone mobile ou un smartphone, comprenant un circuit intégré radiofréquence comportant le circuit électronique de filtrage tel que décrit.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe, schématique et partielle, d'un exemple d'un circuit électronique de filtrage selon un mode de réalisation ;
la figure 2A, la figure 2B, la figure 2C, la figure 2D et la figure 2E sont chacune une vue en coupe, schématique et partielle, d'une structure obtenue à l'issue d'une étape d'un procédé de fabrication d'un dispositif passif intégré selon un mode de réalisation ;
la figure 3A, la figure 3B et la figure 3C sont chacune une vue en coupe, schématique et partielle, d'une structure obtenue à l'issue d'une étape d'un procédé de fabrication d'un circuit électronique de filtrage selon un mode de réalisation ; et
la figure 4 est une vue de dessus, schématique et partielle, d'un exemple d'un dispositif intégrant un circuit électronique de filtrage.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les applications des circuits électroniques de filtrage n'ont pas été détaillées, les modes de réalisation décrits étant compatibles avec toutes ou la plupart des applications des circuits électroniques de filtrage, moyennant éventuellement des adaptations à la portée de la personne du métier à la lecture de la présente description.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais « coupled ») entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes « avant », « arrière », « haut », « bas », « gauche », « droite », etc., ou relative, tels que les termes « dessus », « dessous », « supérieur », « inférieur », etc., ou à des qualificatifs d'orientation, tels que les termes « horizontal », « vertical », etc., il est fait référence, sauf précision contraire, à l'orientation des figures.

Sauf précision contraire, les expressions « environ », « approximativement », « sensiblement », et « de l'ordre de » signifient à 10 % près, de préférence à 5 % près.

Dans la description qui suit, les qualificatifs « isolant » et « conducteur » signifient respectivement, sauf précision contraire, électriquement isolant et électriquement conducteur.

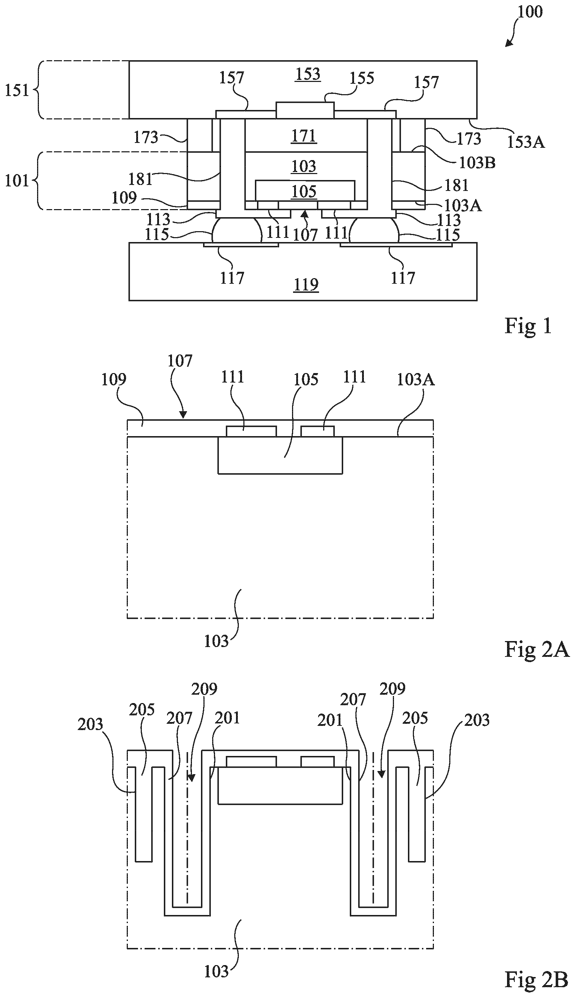

La figure 1 est une vue en coupe, schématique et partielle, d'un exemple d'un circuit électronique de filtrage 100 selon un mode de réalisation.

Dans l'exemple représenté, le circuit électronique de filtrage 100 comprend un dispositif passif intégré 101 comportant un substrat semiconducteur 103, par exemple un morceau de plaquette en un matériau semiconducteur tel que le silicium. Dans cet exemple, le substrat semiconducteur 103 comprend une région 105 affleurant une face 103A du substrat semiconducteur 103 (la face inférieure du substrat 103, dans l'orientation de la figure 1) et dans laquelle est par exemple formé au moins un filtre passe-bande, par exemple un filtre IPD (de l'anglais « Integrated Passive Device » - dispositif passif intégré). La région 105 comporte par exemple plusieurs composants électroniques passifs, par exemple choisis chacun parmi :
- un composant résistif, par exemple une résistance ;
- un composant capacitif, par exemple un condensateur ; et
- un composant inductif, par exemple une inductance.

À titre d'exemple, la région 105 comprend un filtre RLC comportant au moins un composant résistif, au moins un composant capacitif et au moins un composant inductif. La structure de la région 105 n'a pas été détaillée en figure 1 afin de ne pas surcharger le dessin. En particulier, les composants électroniques passifs formés dans la région 105 du substrat semiconducteur 103 n'ont pas été représentés.

Dans l'exemple illustré, le dispositif passif intégré 101 comprend en outre une structure d'interconnexion 107 revêtant la face 103A du substrat semiconducteur 103. La structure d'interconnexion 107 comprend par exemple un empilement de couches isolantes 109 et de pistes conductrices 111 situées dans et/ou entre les couches isolantes 109, certaines des pistes conductrices 111 étant en contact avec la région 105.

Dans l'exemple représenté, chaque piste conductrice 111 est connectée à un élément de reprise de contact 113 situé sur la face 103A du substrat semiconducteur 103. Les pistes conductrices 111 permettent par exemple de connecter les éléments de reprise de contact 113 à des bornes des composants électroniques passifs formés dans la région 105. Les éléments de reprise de contact 113 sont par exemple destinés à être connectés à des éléments extérieurs au circuit 100. Dans l'exemple illustré, les éléments de reprise de contact 113 sont connectés chacun, par une bille de soudure 115, à un élément de reprise de contact 117 porté par un substrat de support 119. À titre d'exemple, le substrat de support 119 est une carte de circuit imprimé. Chaque élément de reprise de contact 117 est par exemple un plot conducteur ou une piste conductrice.

Dans l'exemple représenté, le circuit 100 comprend en outre un filtre à ondes acoustiques de volume 151 (« Bulk Acoustic Wave » - BAW, en anglais), ou filtre BAW, superposé au dispositif passif intégré 101 du côté d'une face 103B du substrat semiconducteur 103 opposée à sa face 103A (du côté de la face supérieure du substrat 103, dans l'orientation de la figure 1). Dans l'exemple représenté, le filtre à ondes acoustiques de volume 151 comprend un substrat semiconducteur 153, par exemple un morceau de plaquette en un matériau semiconducteur tel que le silicium, dans et sur lequel est formée une structure de filtre à ondes acoustiques de volume 155 connectée à des électrodes 157.

La structure 155 est par exemple de type FBAR (de l'anglais « thin-Film Bulk Acoustic Resonator » - résonateur acoustique en volume à film mince), également appelée filtre à ondes acoustiques de volume « à membrane ». Dans ce cas, la structure 155 comprend par exemple une membrane en un matériau isolant suspendue au-dessus d'une cavité remplie d'air formée dans le substrat 153 et au moins une couche piézoélectrique située sur la membrane, par exemple interposée entre les électrodes 157. La structure 155 n'a pas été détaillée en figure 1 afin de ne pas surcharger le dessin. À titre de variante, la structure 155 peut être de type SMR (de l'anglais « Solidly Mounted Resonator » - résonateur monté rigidement). Dans ce cas, la structure 155 comprend par exemple une membrane en un matériau isolant située sur et en contact avec un miroir de Bragg et au moins une couche piézoélectrique située sur la membrane, par exemple interposée entre les électrodes 157.

Dans l'exemple illustré, le dispositif passif intégré 101 est séparé du filtre à ondes acoustiques de volume 151 par une cavité 171. Dans cet exemple, la cavité 171 s'étend verticalement depuis la face 103B du substrat semiconducteur 103 (c'est-à-dire depuis la face supérieure du dispositif passif intégré 101, dans l'orientation de la figure 1) jusqu'à une face 153A du substrat semiconducteur 153 du filtre à ondes acoustiques de volume 151 située en vis-à-vis de la face 103B (c'est-à-dire jusqu'à la face inférieure du filtre à ondes acoustiques de volume 151, dans l'orientation de la figure 1). Dans l'exemple représenté, la cavité 171 est délimitée latéralement, ou bordée latéralement, par un mur périphérique 173. Dans l'exemple illustré en figure 1, le mur périphérique 173 s'étend verticalement depuis la face 103B du substrat 103 jusqu'à la face 153A du substrat 153. À titre d'exemple, le mur périphérique 173 est en un matériau isolant, par exemple un polymère. La cavité 171 définie par le mur 173 et par les faces 103B et 153A est par exemple remplie d'air. À titre de variante, l'intérieur de la cavité 171 peut être soumis à un vide partiel.

Dans l'exemple représenté, le circuit 100 comprend en outre des piliers conducteurs 181 traversant le dispositif passif intégré 101 et connectant chacun l'une des électrodes 157 du filtre à ondes acoustiques de volume 151 à l'un des éléments de reprise de contact 113. Dans l'exemple illustré, chaque pilier conducteur 181 forme saillie sur la face 103B du substrat semiconducteur 103, traverse la cavité 171 et est situé sur et en contact avec l'une des électrodes 157. À titre d'exemple, la hauteur de chaque pilier 181 définit la hauteur, ou épaisseur, de la cavité 171.

Le mur périphérique 173 présente par exemple, en vue de dessus, une forme annulaire entourant les piliers conducteurs 181. Cela permet avantageusement de protéger les piliers conducteurs 181 contre des agressions externes, par exemple des chocs mécaniques. Cela permet en outre de réduire les dimensions latérales du circuit électronique de filtrage, par exemple par rapport à une structure dans laquelle les électrodes 157 du filtre BAW 151 seraient connectées aux éléments de reprise de contact 117 du substrat de support 119 par des piliers situés à l'extérieur de la cavité 171. À titre d'exemple, le mur périphérique 173 présente, en vue de dessus, un pourtour de forme quelconque, par exemple sensiblement rectangulaire, ovale, carrée, circulaire, etc. La cavité 171 est par exemple hermétique, ou scellée. Cela permet d'éviter que des particules ou de l'humidité ne pénètrent à l'intérieur de la cavité 171. À titre de variante, le mur périphérique 173 peut comporter des ouvertures permettant notamment des échanges d'air entre l'intérieur de la cavité 171 et le milieu extérieur. Cela favorise par exemple un équilibre de pressions entre l'intérieur et l'extérieur de la cavité 171, par exemple afin de tenir compte d'un échauffement du circuit 100 lors de son fonctionnement.

Dans le circuit 100, le dispositif passif intégré 101 fait avantageusement office de capot, ou couvercle, du filtre à ondes acoustiques de volume 151. Cela permet avantageusement d'éviter l'utilisation d'un capot dédié ne comprenant aucun composant électronique. En d'autres termes, l'utilisation du dispositif passif intégré 101 en tant que capot du filtre à ondes acoustiques de volume 151 permet de combiner, dans un même élément, une fonction de protection mécanique, procurée notamment par le substrat 103 et le mur périphérique 173, et une fonction de filtrage, réalisée notamment par la région 105.

La figure 1 illustre un exemple dans lequel le circuit 100 comprend deux piliers conducteurs 181 connectant chacun l'un des éléments de reprise de contact 113 du dispositif passif intégré 101 à l'une des électrodes 157 du filtre à ondes acoustiques de volume 151. Cet exemple n'est toutefois pas limitatif, le circuit 100 pouvant plus généralement comprendre un nombre entier, supérieur ou égal à un, de piliers conducteurs connectant chacun un élément de reprise de contact du dispositif passif intégré 101 à une électrode du filtre à ondes acoustiques de volume 151.

Les filtres utilisant un dispositif passif intégré présentent avantageusement, dans des bandes d'atténuation situées de part et d'autre de leur bande passante, des performances de réjection élevées. Toutefois, ces filtres ont pour inconvénient de présenter, interposées entre leur bande passante et chacune de leurs bandes d'atténuation, des bandes de transition larges. À l'inverse, les filtres à ondes acoustiques de volume ont pour avantage de présenter des bandes de transition moins larges que celles des filtres utilisant un dispositif passif intégré, mais souffrent de performances de réjection inférieures. Le fait de combiner, dans le circuit 100, le dispositif passif intégré 101 et le filtre à ondes acoustiques de volume 151 permet d'associer les avantages et d'éliminer, ou de diminuer, les inconvénients de ces deux types de filtres. Le circuit 100 présente par exemple ainsi une bande de transition plus étroite que celle du dispositif passif intégré 101 pris isolément, et des performances de réjection supérieures à celles du filtre à ondes acoustiques de volume 151 pris isolément.

Par ailleurs, du fait que le dispositif passif intégré 101 et le filtre à ondes acoustiques de volume 151 du circuit 100 sont superposés, il en résulte avantageusement un gain de place. Cela permet en outre de prévoir des connexions moins longues, donc des résistance moins importantes, entre le dispositif passif intégré 101 et le filtre à ondes acoustiques de volume 151.

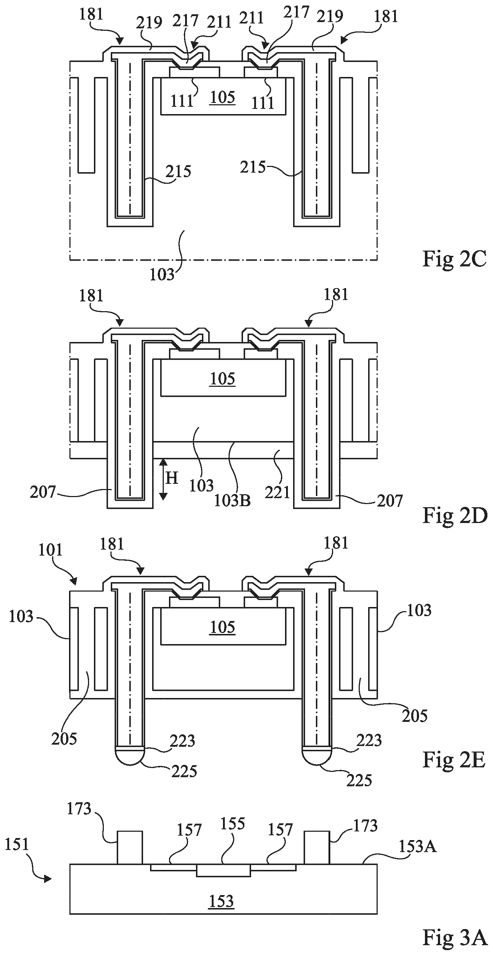

La figure 2A, la figure 2B, la figure 2C, la figure 2D et la figure 2E sont chacune une vue en coupe, schématique et partielle, d'une structure obtenue à l'issue d'une étape d'un procédé de fabrication du dispositif passif intégré 101 selon un mode de réalisation.

La figure 2A représente la structure obtenue après la formation de la région 105 et la formation de la structure d'interconnexion 107 sur la face 103A du substrat 103. Un ou des composants électroniques, non représentés, sont formés dans et/ou sur la région 105. Selon un mode de réalisation, à ce stade du procédé, le substrat 103 correspond à une plaquette, et les régions 105 de plusieurs dispositifs passifs intégrés sont formées dans et/ou sur le substrat 103, les régions 105 pouvant être identiques ou différentes. En figure 2A, une seule région 105 est représentée et la structure d'interconnexion 107 comprend les pistes conductrices 111 connectées à la région 105 et la couche isolante 109 recouvrant les pistes conductrices 111 et la face 103A du substrat 103 autour des pistes conductrices 111. À ce stade du procédé, l'épaisseur du substrat 103 est strictement supérieure à l'épaisseur finale souhaitée du substrat 103. L'épaisseur du substrat 103, à ce stade du procédé, est par exemple comprise entre 500 µm et 1,3 mm.

La figure 2B représente la structure obtenue après la formation d'une ouverture 201 à l'emplacement souhaité de chaque pilier de connexion 181 et la formation d'une ouverture 203 à l'emplacement souhaité de murs isolants 205. Les ouvertures 201 et 203 traversent complètement la structure d'interconnexion 107 et s'étendent sur une partie de l'épaisseur du substrat 103 depuis la face 103A. Les ouvertures 201 ont la même profondeur et les ouvertures 203 ont la même profondeur. La profondeur des ouvertures 201 est supérieure à la profondeur des ouvertures 203. La profondeur des ouvertures 203 est par exemple sensiblement égale à l'épaisseur finale souhaitée du substrat 103. La profondeur des ouvertures 203 est par exemple comprise entre 50 et 300 µm. Les ouvertures 201 et 203 sont par exemple réalisées par des étapes de gravure ionique réactive profonde (« Deep Reactive Ion Etching » - DRIE, en anglais). Selon le procédé utilisé pour la formation des ouvertures 201 et 203, les ouvertures 201 et les ouvertures 203 peuvent être réalisées simultanément ou peuvent être réalisées à des étapes séparées. En particulier, avec une gravure ionique réactive profonde, la vitesse de gravure dépend du diamètre de l'ouverture de sorte que les ouvertures 203, qui présentent par exemple une largeur inférieure au diamètre moyen des ouvertures 201, peuvent être réalisées simultanément aux ouvertures 201.

Chaque ouverture 201 peut présenter une section de forme quelconque. À titre d'exemple, chaque ouverture 201 présente, en vue de dessus, une forme sensiblement circulaire, une forme rectangulaire à coins arrondis, une forme ovale, etc. Les ouvertures 201 présentent par exemple une profondeur fonction de la hauteur souhaitée des piliers 181.

La figure 2B représente en outre la structure obtenue après la formation d'une couche isolante 207 dans chaque ouverture 201 et la formation du mur isolant 205 dans chaque ouverture 203. À ce stade du procédé, la couche isolante 207 revêt les parois latérales et le fond de l'ouverture 201. Cette étape peut comprendre le dépôt d'une couche isolante simultanément sur les parois de l'ouverture 203 et sur les parois de l'ouverture 201, l'épaisseur de la couche isolante étant telle qu'elle comble, c'est-à-dire remplit totalement, l'ouverture 203 mais ne comble pas chaque ouverture 201 de sorte qu'une cavité 209 est présente dans chaque ouverture 201 après la formation de la couche isolante.

La figure 2C représente la structure obtenue après la formation, pour chaque pilier de connexion à réaliser, d'une ouverture 211 dans la couche isolante 109 pour exposer l'une des pistes conductrices 111, le dépôt d'un masque (non représenté) sur la couche isolante 207 comprenant, pour chaque pilier de connexion à réaliser, une ouverture exposant la cavité 209, l'ouverture 211 et la partie de la couche isolante 109 reliant la cavité 209 à l'ouverture 211, et la formation d'une couche d'interface 215 dans chaque ouverture. À ce stade du procédé, la couche d'interface 215 recouvre toutes les parois de la cavité 209, notamment les parois latérales et le fond de la cavité 209, les parois de l'ouverture 211, et la partie exposée de la couche isolante 109 reliant la cavité 209 à l'ouverture 211 correspondante. Le masque peut correspondre à un film qui est appliqué sur la couche isolante 109.

La figure 2C représente en outre la structure obtenue après, pour chaque pilier de connexion à réaliser, un remplissage complet de chaque cavité 209 d'un matériau conducteur, formant ainsi un tronc du pilier de connexion 181, et la formation d'une portion de connexion 217 de chaque pilier de connexion. La portion de connexion 217 correspond par exemple à l'un des éléments de reprise de contact 113 du circuit 100. Le matériau conducteur composant le tronc peut être déposé par électrodéposition sur la couche d'interface 215. Dans ce cas, le dépôt du matériau conducteur est réalisé à partir de la couche d'interface 215 selon une direction sensiblement perpendiculaire à la couche d'interface 215. Ceci permet de façon avantageuse de remplir la cavité 209 même si le facteur de forme de la cavité 209, c'est-à-dire le rapport entre la hauteur de la cavité et le diamètre de la cavité est élevé, puisque le dépôt du matériau conducteur est réalisé notamment depuis les parois latérales de la cavité 209.

La figure 2C représente en outre la structure obtenue après le retrait du film et la formation, pour chaque pilier de connexion 181, d'une couche isolante 219 recouvrant la portion de connexion 217.

La figure 2D représente la structure obtenue après une gravure du substrat 103 depuis sa face 103B. À la fin de l'étape de gravure, pour chaque pilier de connexion 181, une partie du tronc, entouré de la couche d'interface 215 et de la couche isolante 207, se projette en saillie du substrat 103 depuis la face 103B sur une hauteur H. La hauteur H correspond par exemple sensiblement à l'épaisseur de la future cavité 171. L'étape de gravure peut comprendre une gravure chimique sélective par rapport au matériau composant la couche isolante 207. La gravure du substrat 103 est par exemple arrêtée lorsque l'extrémité du mur affleure la face inférieure 103B. La hauteur H est fixée par l'étape de gravure.

La figure 2D représente en outre la structure obtenue après la formation d'une couche isolante 221 sur la face 103B du substrat 103. La couche isolante 221 est par exemple en le même matériau que la couche isolante 207 et l'épaisseur de la couche isolante 221 est par exemple, à cette étape du procédé, sensiblement égale à la somme de l'épaisseur de la couche isolante 207 et de l'épaisseur finale souhaitée de la couche isolante 221, par exemple égale au double de l'épaisseur de la couche isolante 207.

La figure 2E représente la structure obtenue après la gravure complète de la portion de la couche isolante 207 qui est exposée du côté de la face 103B du substrat 103. Cette étape peut en outre entraîner la gravure de la couche isolante 221 sur l'épaisseur de la couche isolante 207. La couche isolante 221 présentant l'épaisseur finale souhaitée est alors obtenue.

La figure 2E représente en outre la structure obtenue après, pour chaque pilier de connexion 181, la gravure de la couche d'interface 215 recouvrant la face d'extrémité, la formation d'une couche de finition 223 et la formation d'un bloc de matériau de liaison 225.

La figure 2E représente en outre la structure obtenue après une étape de découpe pour séparer les dispositifs passifs intégrés 101. À titre d'exemple, les lignes de découpe sont situées entre les murs 205 de dispositifs 101 adjacents.

Chaque dispositif passif intégré 101 ainsi individualisé peut alors être fixé à un élément extérieur, par exemple le substrat de support 119. Le mur 205 protège la région 105 du dispositif passif intégré 101 notamment contre des décharges électrostatiques au niveau des parois latérales du dispositif 101 lors de la manipulation et la fixation du dispositif 101 à l'élément extérieur.

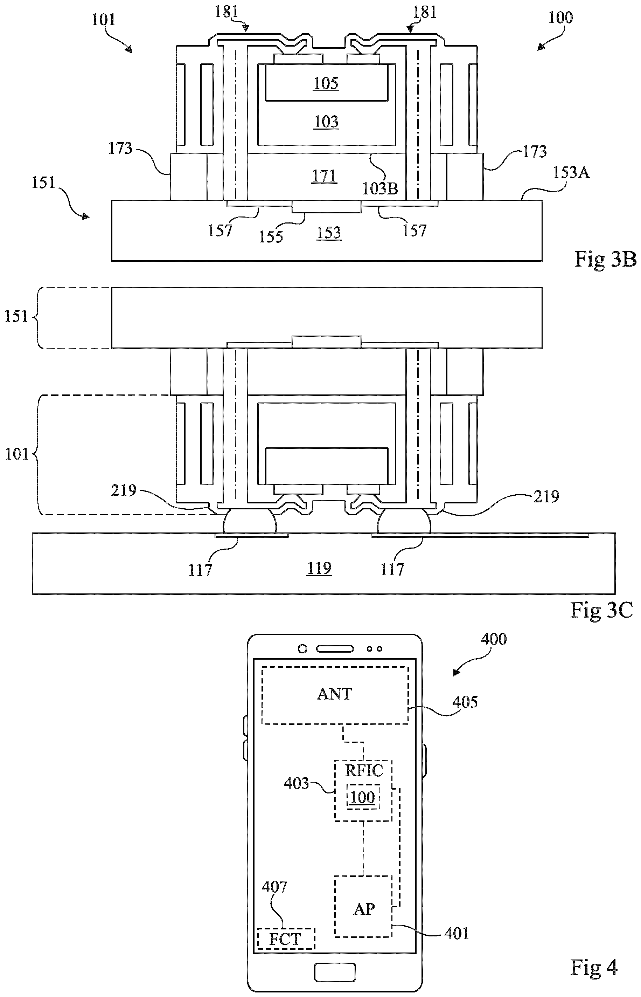

La figure 3A, la figure 3B et la figure 3C sont chacune une vue en coupe, schématique et partielle, d'une structure obtenue à l'issue d'une étape d'un procédé de fabrication d'un circuit électronique de filtrage, par exemple le circuit 100 de la figure 1, selon un mode de réalisation. Les étapes décrites ci-après en relation avec les figures 3A à 3C peuvent indifféremment être mises en oeuvre avant, pendant ou après les étapes de réalisation du dispositif passif intégré 101 précédemment décrites en relation avec les figures 2A à 2E.

La figure 3A représente la structure obtenue après la formation de la structure 155 dans et sur le substrat semiconducteur 153, et après la formation des électrodes 157.

La figure 3A représente en outre la structure obtenue après la formation du mur périphérique 173 sur la face 153A du substrat semiconducteur 153. À l'issue de cette étape, le mur périphérique 173 présente par exemple une hauteur sensiblement égale à la hauteur H des piliers 181.

La figure 3B représente la structure obtenue après report du dispositif passif intégré 101 de la figure 2E sur le filtre à ondes acoustiques de volume 151 de la figure 3A. À titre d'exemple, le dispositif passif intégré 101 est retourné par rapport à l'orientation de la figure 2E, de sorte que la face 103B du substrat semiconducteur 103 soit située en vis-à-vis de la face 153A du filtre à ondes acoustiques de volume 151. Les blocs en matériau de liaison 225 du dispositif passif intégré 101 sont par exemple ensuite mis en contact avec les électrodes 157 du filtre à ondes acoustiques de volume 151, le mur périphérique 173 venant prendre appui sur la face 103B du substrat semiconducteur 103. Le circuit électronique de filtrage 100 est par exemple ainsi obtenu.

La figure 3C représente la structure obtenue après fixation du circuit électronique de filtrage 100 sur le substrat de support 119. À titre d'exemple, la couche isolante 219 est préalablement ouverte à l'aplomb des éléments de reprise de contact 113 afin de libérer leur face opposée aux piliers 181. Le circuit 100 est par exemple ensuite reporté sur le substrat de support 119 de sorte que la face 103A du substrat semiconducteur 103 soit située en vis-à-vis des éléments de reprise de contact 117 du substrat de support 119.

La figure 4 est une vue de dessus, schématique et partielle, d'un exemple d'un dispositif 400 intégrant un circuit électronique de filtrage, par exemple le circuit 100. Dans l'exemple représenté, le dispositif 400 est un téléphone mobile, ou smartphone.

Dans cet exemple, le dispositif 400 comprend un circuit de traitement 401 (AP), par exemple un microcontrôleur ou un microprocesseur principal du dispositif 400. Le circuit de traitement 401 est par exemple connecté à un circuit intégré radiofréquence 403 (RFIC) comprenant le circuit électronique de filtrage 100. Dans l'exemple illustré, le circuit intégré radiofréquence 403 est connecté à une antenne 405 (ANT), par exemple une antenne de communication radiofréquence du dispositif 400. Bien que cela n'ait pas été détaillé en figure 4 afin de ne pas surcharger le dessin, le circuit intégré radiofréquence 403 peut en outre comprendre des composants et circuits destinés à mettre en oeuvre des fonctions d'adaptation d'impédance, d'amplification, de modulation/démodulation, de commutation, etc.

Le dispositif 400 peut en outre comprendre d'autres éléments, par exemple d'autres composants électroniques ou circuits non détaillés en figure 4. Ces éléments ont été symbolisés, en figure 4, par un bloc fonctionnel 407 (FCT).

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, la personne du métier est capable, à partir des indications de la présente description, de prévoir et de fabriquer un circuit analogue au circuit 100 mais comprenant plusieurs dispositifs passifs intégrés 101 empilés les uns sur les autres.

Par ailleurs, bien que la figure 4 prenne pour exemple le cas d'une intégration du circuit 100 à un téléphone mobile ou un smartphone, les modes de réalisation décrits ne se limitent pas à cet exemple mais s'appliquent plus généralement à tout dispositif ou système doté de fonctions de communication sans fil, par exemple dans le domaine de la télématique. En particulier, le circuit 100 peut être intégré dans des véhicules automobiles, par exemple pour mettre en oeuvre des fonctionnalités d'accès à Internet sans fil, de communication du véhicule avec des équipements ou systèmes extérieurs, de conduite autonome, etc.

Enfin, la mise en oeuvre pratique des modes de réalisation et variantes décrits est à la portée de la personne du métier à partir des indications fonctionnelles données ci-dessus. En particulier, les modes de réalisation décrits ne se limitent pas aux exemples particuliers de matériaux et de dimensions mentionnés dans la présente description.

## Revendications

1. Circuit électronique de filtrage (100) comprenant :
- un dispositif passif intégré (101) ;
- un filtre à ondes acoustiques de volume (151) superposé au dispositif passif intégré (101) du côté d'une première face (103B) du dispositif passif intégré (101) ; et
- au moins un pilier conducteur (181) traversant le dispositif passif intégré (101) et connectant une électrode (157) du filtre à ondes acoustiques de volume (151) à un élément de reprise de contact (113) situé sur une deuxième face (103A) du dispositif passif intégré (101) opposée à la première face (103B) et destiné à être connecté à un élément extérieur (117).

2. Circuit (100) selon la revendication 1, dans lequel le dispositif passif intégré forme un capot du filtre à ondes acoustiques de volume.

3. Circuit (100) selon la revendication 1 ou 2, dans lequel la première face (103B) délimite, avec une troisième face (153A) du filtre à ondes acoustiques de volume (151) située en vis-à-vis de la première face (103B), une cavité (171).

4. Circuit (100) selon la revendication 3, dans lequel la cavité (171) présente une épaisseur définie par une hauteur (H) dudit au moins un pilier conducteur (181), ledit au moins un pilier conducteur (181) formant saillie sur la première face (103B).

5. Circuit (100) selon la revendication 3 ou 4, dans lequel la cavité (171) est délimitée latéralement par un mur périphérique (173).

6. Circuit (100) selon la revendication 5, dans lequel le mur périphérique (173) est en un matériau isolant, de préférence un matériau polymère.

7. Circuit (100) selon l'une quelconque des revendications 3 à 6, dans lequel ledit au moins un pilier conducteur (181) est situé à l'intérieur de la cavité (171).

8. Circuit (100) selon l'une quelconque des revendications 1 à 7, dans lequel le dispositif passif intégré (101) comporte un premier substrat semiconducteur (103) comprenant une région (105) dans et sur laquelle est formé au moins un filtre, de préférence au moins un filtre passe-bande, plus préférentiellement un filtre RLC.

9. Circuit (100) selon l'une quelconque des revendications 1 à 8, dans lequel le filtre à ondes acoustiques de volume (151) comporte un deuxième substrat semiconducteur (153) comprenant une région (155) dans et sur laquelle est formée une structure de filtre à ondes acoustiques de volume connectée à l'électrode (157).

10. Dispositif électronique (400), de préférence téléphone mobile ou smartphone, comprenant un circuit intégré radiofréquence (403) comportant le circuit électronique de filtrage (100) selon l'une quelconque des revendications 1 à 9.
